# EUROPÄISCHE PATENTSCHRIFT

(11) **EP 2 817 976 B1**
(45) Veröffentlichungstag und Bekanntmachung des Hinweises auf die Patenterteilung: **18.05.2016**
(21) Anmeldenummer: 13700931.2
(22) Anmeldetag: 24.01.2013
(51) Int. Cl.: H04Q 9/00, G01R 31/36, H01M 10/42, H01M 10/48

(54) **BATTERIESENSORDATENÜBERTRAGUNGSEINHEIT UND EIN VERFAHREN ZUM ÜBERTRAGEN VON BATTERIESENSORDATEN**
BATTERY SENSOR DATA TRANSMISSION UNIT AND A METHOD FOR TRANSMITTING BATTERY SENSOR DATA
UNITÉ DE TRANSMISSION DE DONNÉES DE DÉTECTION DE BATTERIE ET PROCÉDÉ DE TRANSMISSION DE DONNÉES DE DÉTECTION DE BATTERIE

(30) Priorität: 23.02.2012 DE 102012202754
(43) Veröffentlichungstag der Anmeldung: 31.12.2014
(73) Patentinhaber: Robert Bosch GmbH, 70442 Stuttgart (DE)
(72) Erfinder: WENZLER, Axel, 78628 Rottweil (DE); ELBRACHT, Berthold, 72768 Reutlingen (DE); SCHNITZER, Reiner, 72762 Reutlingen (DE); SCHIEMANN, Werner, 70734 Fellbach (DE); HENRICI, Fabian, 70195 Stuttgart (DE)
(86) Internationale Anmeldenummer: PCT/EP2013/051264
(87) Internationale Veröffentlichungsnummer: WO 2013/124111

(56) Entgegenhaltungen:
- DE-A1-102008 010 971
- US-A1- 2007 080 662

## Beschreibung

### Stand der Technik

Die vorliegende Erfindung bezieht sich auf eine Batteriesensordatenübertragungseinheit, ein Verfahren zum Übertragen von Batteriesensordaten sowie auf ein entsprechendes Computerprogrammprodukt gemäß den Hauptansprüchen.

Speziell in der Fahrzeugtechnik werden vermehrt Batterien eingesetzt, um einen Elektromotor zur Fortbewegung der Fahrzeuge betreiben zu können. In diesem Zusammenhang ist die Zustandsüberwachung der Batterien von erhöhter Bedeutung, um einem Nutzer des Fahrzeugs frühzeitig ein möglicherweise bevorstehendes Problem mit der Antriebseinheit bzw. einem Ausfall der Batterien mitteilen zu können. Hierzu wurde vorgeschlagen, innerhalb der Batterie eine Erfassung und Übertragung von Sensorsignalen über dedizierte Datenleitungen, z. B. den CAN-Bus, vorzunehmen. Relevante Daten über einen Zustand der Batterie werden über einen oder mehrere Batteriesensoren erfasst und an ein Steuer- bzw. Auswertungsgerät übermittelt.

Die DE 10 2009 036 086 A1 offenbart eine Überwachungselektronik für eine Batterie mit einer Mehrzahl von Zellen, wobei die Überwachungselektronik eine Mehrzahl von Zell-Überwachungsschaltkreisen aufweist, welche an einer flexiblen Platine befestigt sind. Insbesondere mag die Überwachungselektronik derart eingerichtet sein, dass sie für jeden Zellpol der Batterie einen Zell-Überwachungsschaltkreis aufweist. Insbesondere mag auch das Vorsehen von möglichst vielen stoffschlüssigen Verbindungen zwischen einer Elektronik und der flexiblen Platane und/oder der flexiblen Platine mit den Zellen und optionalen Temperatursensoren eine erhöhte Lebensdauer bei geringen Fehlerraten ermöglichen.

Die DE 10 2008 010 971 A1 offenbart ein Schutzsystem zur elektrischen Abschaltung und/oder Überbrückung wenigstens einer in einem Batteriemodul angeordneten Batteriezelle.

### Offenbarung der Erfindung

Vor diesem Hintergrund wird mit der vorliegenden Erfindung eine Batteriesensordatenübertragungseinheit, ein Verfahren zum Übertragen von Batteriesensordaten sowie auf ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Die vorliegende Erfindung schafft eine Batteriesensordatenübertragungseinheit mit folgenden Merkmalen:
- einer Verschaltungszustandsermittlungseinheit zur Ermittlung eines Serienschaltungszustandes, in dem eine Batteriezelle mit einer weiteren Batteriezelle mittels einer Energieübertragungsleitung in Reihe geschaltet ist und/oder zur Bestimmung eines Überbrückungszustandes, in dem zumindest ein Pol der Batteriezelle entkoppelt von zumindest einer weiteren Batteriezelle ist; und
- eine Datenübermittlungseinheit, die ausgebildet ist, um ein Sensorsignal, welches eine physikalische Größe in oder an der Batteriezelle repräsentiert, in dem Serienschaltungszustand unter Verwendung der Energieübertragungsleitung an ein Auswertungsgerät auszugeben und/oder um das Sensorsignal in dem Überbrückungszustand unter Verwendung einer Batteriegehäusewand als Übertragungsmedium an das Auswertungsgerät auszugeben.

Unter einer (Batteriesensordatenübertragungs-) Einheit kann vorliegend eine Vorrichtung oder ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Ferner schafft die vorliegende Erfindung ein Verfahren zur Übertragung von Batteriesensordaten, wobei das Verfahren die folgenden Schritte aufweist:
- Ermitteln eines Serienschaltungszustandes, in dem eine Batteriezelle mit zumindest einer weiteren Batteriezelle mittels einer Energieübertragungsleitung in Reihe geschaltet ist und/oder Ermitteln eines Überbrückungszustandes, in dem ein Pol der Batteriezelle entkoppelt von zumindest einer weiteren Batteriezelle ist; und
- Ausgeben eines Sensorsignals, welches eine physikalische Größe in oder an der Batteriezelle repräsentiert, in dem Serienschaltungszustand unter Verwendung der Energieübertragungsleitung an ein Auswertungsgerät und/oder Ausgeben des Sensorsignals in dem Überbrückungszustand unter Verwendung einer Batteriegehäusewand als Übertragungsmedium an das Auswertungsgerät.

Von Vorteil ist auch ein Computerprogramm mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Computerprogramm auf einer Einheit, einem Computer oder einer Vorrichtung ausgeführt wird.

Unter einer Verschaltungszustandsermittlungseinheit kann eine Einrichtung oder ein Modul verstanden werden, welches dazu ausgelegt ist, einen Serienschaltungszustand und/oder einen Überbrückungszustand bei einer elektrischen Kopplung (oder Nicht-Kopplung) von mehreren Batteriezellen zu bestimmen. Unter einer Energieübertragungsleitung kann eine elektrische Leitung verstanden werden, über welche neben einem Stromfluss zur Übertragung von einer elektrischen Energie noch ein Datensignal aufmoduliert werden kann. Unter einem Serienschaltungszustand kann dabei ein Zustand verstanden werden, in dem ein Pol einer Batteriezelle in Serie mit zumindest einem Pol einer weiteren Batteriezelle elektrisch leitfähig als eine Energieübertragungsleitung verbunden ist. Im Serienschaltungszustand im kann somit die Batteriezelle als in Serie mit zumindest einer weiteren Batteriezelle geschaltet verstanden werden, sodass sich an zwei Endabgriffsklemmen einer solchen Serienschaltung des die Spannungen an den jeweiligen Polen der beiden in Serie geschaltet und Batteriezellen addieren. Unter einem Überbrückungszustand kann ein Zustand verstanden werden, in dem der Pol der Batteriezelle nicht mit einem anderen Pol einer weiteren Batteriezelle verbunden, d. h. in dem der Pol der Batteriezelle entkoppelt von einem anderen Pol einer weiteren Batteriezelle ist. Sind dagegen mehrere weitere Batteriezellen in Serie geschaltet, ohne dass die betreffende Batteriezelle in diese Serienschaltung eingebunden ist, wird von der Verschaltungszustandsermittlungseinheit der Übertragungszustand bestimmt, in dem die betreffende Batteriezelle elektrisch lediglich in einen Nebenast der Energieübertragungsleitung geschaltet ist. In einem solchen Übertragungszustand ist die Spannung zwischen zwei Polen der betreffenden Batteriezelle nicht zur Erhöhung der Spannung zwischen den Endabgriffsklemmen verwendbar. Unter einer Datenübermittlungseinheit kann eine Einrichtung oder ein Modul verstanden werden, um ein Sensorsignal aufzubereiten und über einen vorbestimmten Übertragungspfad an ein Auswertungsgerät zu übertragen. Dieser vorbestimmte Übertragungspfad kann in Abhängigkeit vom bestimmten Serienschaltungszustand oder Überbrückungszustand von der Datenübermittlungseinheit ausgewählt werden. Unter einem Sensorsignal kann ein Signal verstanden werden, dass eine physikalische Größe wie beispielsweise einen Druck oder eine Temperatur in oder an der betreffenden Batteriezelle repräsentiert. Im Serienschaltungszustand kann dabei das Sensorsignal direkt über die Energieübertragungsleitung übermittelt werden. In diesem Fall kann das Sensorsignal beispielsweise unter Verwendung einer PowerlineÜbertragungstechnik ohne die Verwendung einer zusätzlichen Datenleitung an das Auswertungsgerät übertragen werden. In dem Überbrückungszustand, in dem zumindest ein Pol der betreffenden Batteriezelle nicht in die Energieübertragungsleitung eingebunden verschaltet ist (d .h. in dem der Pol der Batteriezelle entkoppelt von einem anderen Pol einer weiteren Batteriezelleist), kann hingegen das Sensorsignal unter Verwendung der Batteriegehäusewand anderes Auswertungsgerät übertragen werden. Diese Batteriegehäusewand kann in diesem Fall als Element verwendet werden, um eine elektrische Leitung durch den Nebenast, in dem die betreffende Batteriezelle im Übertragungszustand elektrisch angeordnet ist, zum Auswertungsgerät zu schließen.

Die vorliegende Erfindung basiert auf der Erkenntnis, dass bei unterschiedlichen Verschaltungen der einzelnen Batteriezellen zur Bereitstellung von unterschiedlichen Spannungsniveaus eine Datenübertragung über die gleiche Leitung erfolgen kann, über die auch die elektrische Energie von den einzelnen Batteriezellen übertragen wird. Ein solcher Ansatz bietet den Vorteil, dass auf eine separate Datenübertragungsleitung verzichtet werden kann, wodurch sich Herstellungskosten für eine Batteriesensordatenübertragungseinheit reduzieren lassen und zugleich durch eine verringerte Bauteilanzahl eine geringere Fehleranfälligkeit sichergestellt werden können. Wird jedoch eine Batteriezelle aus dieser Serienschaltung ausgekoppelt, würden sich die Sensordaten, die eine physikalische Größe, die diese spezielle ausgekoppelte Batteriezelle repräsentiert, nicht mehr zum Auswertungsgerät übertragen lassen. In einem solchen Fall lässt sich die betreffende, von der Energieübertragungsleitung teilweise abgekoppelte Batteriezelle in einem "separaten" Stromkreis schalten, der über eine Batteriegehäusewand geschlossen wird und somit auch im Übertragungszustand eine Übertragung des Sensorsignals zum Auswertungsgerät ermöglicht. Auf diese Weise lässt sich auf einfache und zuverlässige Weise eine kontinuierliche und weitgehend unterbrechungsfreie Auswertung von einer oder mehreren in einem oder mehreren Sensorsignalen enthaltenen physikalischen Größe(n) auswerten.

Gemäß einer günstigen Ausführungsform der vorliegenden Erfindung kann die Verschaltungszustandsermittlungseinheit ausgebildet sein, um den Serienschaltungszustand dann zu bestimmen, wenn Pole von zumindest drei Batteriezellen unter Verwendung der Energieübertragungsleitung in Reihe geschaltet sind. Eine derartige Ausführungsform der vorliegenden Erfindung bietet den Vorteil, dass eine Energieübertragungsleitung aufgebaut werden kann, über welche beispielsweise durch ein Multiplexen von unterschiedlichen Kombinationen einer Verschaltung der einzelnen Batteriezellen unterschiedliche Spannungspegel an den Abgriffsklemmen der Energieübertragungsleitung erreichbar sind. Bei einer derartig flexibel verschaltbaren Energieübertragungsleitung besteht ein besonders hoher Bedarf für eine zuverlässige und robuste Übertragung von Datensignalen über diese Energieübertragungsleitung, auch wenn einzelne Batteriezellen aus der Serienschaltung dieser Energieübertragungsleitung abgekoppelt werden.

Auch kann gemäß einer weiteren Ausführungsform der vorliegenden Erfindung die Verschaltungszustandsermittlungseinheit ausgebildet sein, um den Serienschaltungszustand oder den Überbrückungszustand unter Auswertung einer Stellung eines Schalters zu bestimmen, der ausgebildet ist, um eine elektrische Kopplung des Pols der Batteriezelle an die Energieübertragungsleitung durchzuführen. Ein solcher Schalter kann beispielsweise ein Multiplexer sein, der die betreffenden Pole von einzelnen Batteriezellen auf unterschiedliche Weise miteinander verschaltet. Eine derartige Ausführungsform der vorliegenden Erfindung bietet Vorteil, dass bereits vorab definierte Schalterstellungen ausgewertet werden können und einen Rückschluss darauf gegeben, ob eine bestimmte Batteriezelle aktuell in eine Serienschaltung einer Energieübertragungsleitung eingebunden ist. Auf diese Weise kann sehr schnell und technisch sehr einfach der Überbrückungszustand bzw. der Serienschaltungszustand einer betreffenden Batteriezelle ermittelt werden.

Gemäß einer besonderen Ausführungsform der vorliegenden Erfindung kann die Verschaltungszustandsermittlungseinheit ausgebildet sein, um den Serienschaltungszustand oder den Überbrückungszustand unter Verwendung eines Messergebnisses in Bezug auf einem Strom-, Energie- und/oder Leistungsfluss über die Energieversorgungsleitung zu ermittlen. Eine derartige Ausführungsform der vorliegenden Erfindung bietet den Vorteil einer technisch einfachen Erkennung, ob die Batteriezelle, die mit der Batteriesensordatenübertragungseinheit gekoppelt ist, in Serie mit weiteren Batteriezellen geschaltet ist, sodass Energie über die Energieversorgungsleitung übertragen wird.

In einer Ausführungsform der erfindungsgemäßen Batteriesensordatenübertragungseinheit, bei der der Schalter unter Verwendung eines Steuersignals, insbesondere eines pulsweitenmodulierten Steuersignals, angesteuert wird, kann vorteilhaft die Datenübermittlungseinheit ausgebildet sein, um eine Ermittlung oder Ausgabe des Sensorsignals mit dem Steuersignal zu synchronisieren. Eine derartige Ausführungsform der vorliegenden Erfindung bietet den Vorteil, dass bereits durch die Auswertung des vorab bekannten pulsweitenmodulierten Steuersignals auch einen Rückschluss auf einen aktuell vorliegenden Serienschaltungszustand oder Überbrückungszustand für eine betreffende Batteriezelle möglich ist, ohne dass hierzu eine Messung oder Bestimmung des aktuellen Verschaltungszustands erforderlich ist. Durch eine Synchronisierung der Ausgabe oder der Ermittlung des Sensorsignals mit dem Steuersignal wird somit eine schnelle und nahezu unterbrechungsfreie Übertragung eines Sensorsignals an das Auswertungsgerät möglich.

Besonders günstig ist eine Ausführungsform der vorliegenden Erfindung, bei der die Datenübermittlungseinheit ausgebildet ist, um das Sensorsignal, in dem Serienschaltungszustand unter Verwendung der Energieübertragungsleitung an ein Auswertungsgerät auszugeben und/oder um das Sensorsignal in dem Überbrückungszustand unter Verwendung einer Batteriegehäusewand als Übertragungsmedium an das Auswertungsgerät auszugeben. Eine derartige Ausführungsform der vorliegenden Erfindung bietet den Vorteil, dass lediglich im Überbrückungszustand das Batteriegehäuse als Übertragungsmedium eines Sensorsignals von einer bestimmten Batteriezelle an das Auswertungsgerät sichergestellt wird. Dies ermöglicht eine einfachere Auswertung bzw. einen einfacheren Empfang der Sensorsignale am Auswertungsgerät, da das Auswertungsgerät zu vorbestimmten Zeitpunkten das Sensorsignal 168 einer bestimmten Batteriezelle lediglich über einen einzigen Übertragungspfad zu erwarten braucht. Zugleich ist sichergestellt, dass möglichst häufig die Energieübertragungsleitung zu Übertragung des Sensorsignals verwendet wird, sodass Störungen minimiert werden können.

Um eine eindeutige Zuordnung von Datensignalen in dem Auswertungsgerät sicherzustellen, kann gemäß einer Ausführungsform der vorliegenden Erfindung die Datenübermittlungseinheit ausgebildet sein, um das Sensorsignal 168 in einem der Batteriezelle eindeutig zuordenbaren Sensorsignalpaket zu codieren. Eine derartige Ausführungsform der vorliegenden Erfindung bietet den Vorteil, dass mehrere Sensorsignale, die physikalische Größen aus unterschiedlichen Batteriezellen repräsentieren, in dem Auswertungsgerät den jeweils betreffenden Batteriezellen eindeutig zugeordnet werden können.

Ferner ist es vorteilhaft, wenn gemäß einer weiteren Ausführungsform der vorliegenden Erfindung eine Batterieeinheit vorgesehen ist, die folgende Merkmale aufweist:
- einen Batteriezellenverbund, der zumindest zwei Batteriezellen umfasst, wobei die Batteriezellen mittels einer Energieübertragungsleitung in Reihe schaltbar sind;
- zumindest einen Sensor zur Bereitstellung eines Messwertes, der eine physikalische Größe in oder an einer der Batteriezellen repräsentiert; und
- zumindest eine Batteriesensordatenübertragungseinheit gemäß einer vorstehend beschriebenen Variante.

Eine derartige Ausführungsform der vorliegenden Erfindung bietet den Vorteil, dass die einzelnen Komponenten optimal aufeinander abgestimmt werden können, sodass eine möglichst störungsarme Übertragung von einem Sensorsignal 168 kann, eine Auswertungseinheit bzw. einem Auswertungsgerät durchgeführt werden kann.

Die Erfindung wird nachstehend anhand der beigefügten Zeichnungen beispielhaft näher erläutert. Es zeigen:
- Fig. 1: ein Blockschaltbild einer Batterieeinheit, in der ein Ausführungsbeispiel der vorliegenden Erfindung verwendet wird;
- Fig. 2: Diagramme, die eine Synchronisation eines Schaltsignals für einen Schalter mit einer Ausgabe des Sensorsignals darstellen; und
- Fig. 3: ein Ablaufdiagramm eines Ausführungsbeispiels der vorliegenden Erfindung als Verfahren.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

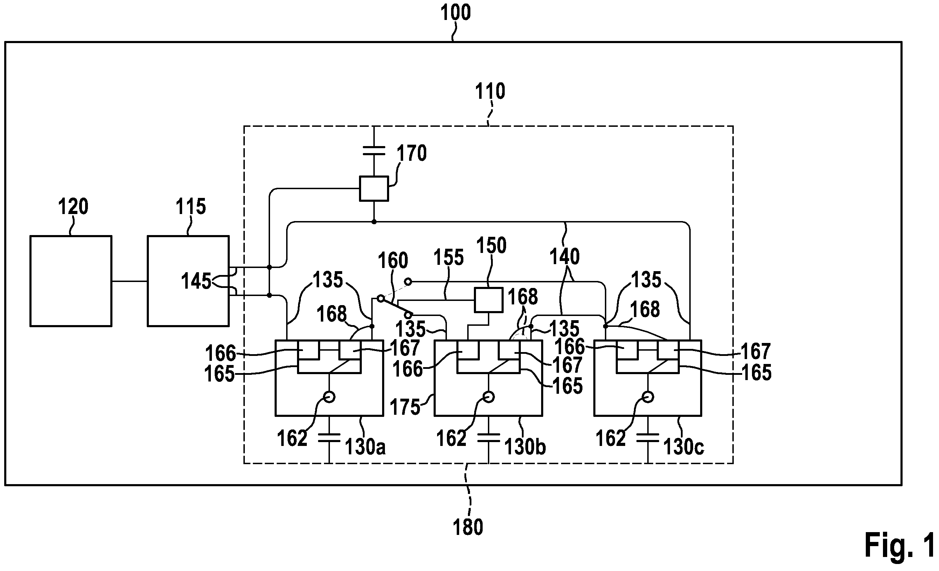

Fig. 1 zeigt ein Blockschaltbild eines Fahrzeugs 100 mit einer Batterieeinheit 110 zur Bereitstellung von elektrischer Energie an eine Leistungselektronikeinheit 115, wobei durch die von der Batterieeinheit 110 bereitgestellte Energie ein Elektromotor 120 betreibbar ist. In der Batterieeinheit 110 sind mehrere Batteriezellen 130 angeordnet, die zur besseren Unterscheidung mit dem Bezugszeichen 130a, 130b und 130c bezeichnet werden. In dem in Fig. 1 dargestellten Ausführungsbeispiel sind alle Batteriezellen 130 identisch aufgebaut, wobei dies nicht notwendigerweise immer zwingend erforderlich ist. Die Pole 135 der Batteriezellen 130 sind in Serie in einer Energieübertragungsleitung 140 miteinander verschaltet, sodass in dem Verschaltungszustand, der in Fig. 1 durchgezogen dargestellt ist, an den Abgriffsklemmen 145 der Batterieeinheit 110 Spannung zur Verfügung steht, die in der Summe der Spannungen zwischen den Polen 135 jeder der drei dargestellten Batteriezellen 130 entspricht. Um nun beispielsweise eine Wechselspannung oder zumindest einen variierenden Spannungspegel an den Klemmen 145 bereitstellen zu können, lässt sich der Verschaltungszustand der einzelnen Batteriezellen 130 mittels einer Verschaltungssteuereinheit 150 steuern. In einem sehr einfachen, nur der prinzipiellen Funktionsweise einer solchen Veränderung des Verschaltungszustandes dienenden Fall den Fig. 1 dargestellt ist, kann ein Schalter 160 durch ein Steuersignal 155 von einer Verschaltungssteuereinheit 150 derart angesteuert werden, dass er von der in Fig. 1 durchgezogen dargestellten Position in eine gestrichelt dargestellte Position gebracht wird, wodurch die im in Fig. 1 dargestellte mittlere Batteriezellen 130b aus der Serienschaltung der Energieübertragungsleitung 140 abgekoppelt wird. Sind jedoch die Pole 135 der mittleren 130b und der rechten Batteriezelle 130c (beispielsweise aus Gründen eines möglichst fehlerrobusten Schaltungsaufbaus) ist die mittlere Batteriezelle 130b als ein Nebenast der Energieversorgungsleitung 140 geschaltet, der für die Bereitstellung des Spannungspegels an den Klemmen 145 nicht relevant ist. In diesem Zustand, in dem die mittlere Batteriezelle 130b von der Serienschaltung abgekoppelt ist, befindet sich diese in einem Zustand, der in der nachfolgenden Beschreibung als Überbrückungszustand bezeichnet wird. Ist der Schalter 160 dagegen in der in Fig. 1 durchgezogen dargestellten Position, befindet sich die in Fig. 1 dargestellte mittlere Batteriezellen 130b in einem Zustand, der in der nachfolgenden Beschreibung als Serienschaltungszustand bezeichnet wird.

Alle in Fig. 1 dargestellten Batteriezellen 130 umfassen je eine Batteriesensordatenübertragungseinheit 165. Die Batteriesensordatenübertragungseinheit 165 umfasst eine Verschaltungszustandsermittlungseinheit 166 und eine mit der Verschaltungszustandsermittlungseinheit 166 gekoppelte Datenübermittlungseinheit 167. Die Verschaltungszustandsermittlungseinheit 166 ist ausgebildet, um einen Verschaltungszustand der betreffenden Batteriezelle 130 (also beispielsweise den Serienschaltungszustand oder den Überbrückungszustand) beispielsweise durch eine Messung des über die Pole der Batteriezelle 130 fließenden Stromes oder der der hierüber fließenden Energie/Leistung zu ermitteln. Die Datenübermittlungseinheit 167 ist ausgebildet, um eine von einem Sensor 162 erfasste physikalische Größe in ein Sensorsignal 168 zu überführen und dieses an ein Auswertungsgerät 170 zu übertragen. Die physikalische Größe, die der jeweils betreffende Sensor 162 erfasst, kann beispielsweise ein Druck oder eine Temperatur sein, der/die in oder an der jeweils betreffenden Batteriezellen 130a, 130b bzw. 130c herrscht. In dem Auswertungsgerät 170 kann eine Überwachung des Zustandes der einzelnen Batteriezellen 130 erfolgen und bei einer Erkennung einer Abweichung der physikalischen Größe in oder an einer der Batteriezellen 130 kann eine Warnung oder Handlungsempfehlung an einen Nutzer der Batterieeinheit 110 ausgegeben werden.

Im Serienschaltungszustand kann die Batteriesensordatenübertragungseinheit 165 das Sensorsignal 168 der jeweils betreffenden Batteriezellen 130 als eine Powerline-Signalübertragung zusätzlich zu der in der Energieversorgungsleitung 140 fließenden Energie auf die Energieversorgungsleitung 140 aufmodulieren, damit das Auswertungsgerät 170 die Sensorsignale von Energieübertragungsleitung 140 ausfiltern und auswerten kann. Wird nun jedoch die in Fig. 1 dargestellte mittlere Batteriezelle 130b durch ein Umschalten des Schalters 160 in den Übertragungszustand geschaltet, um an den Klemmen 145 einen sich ändernden Spannungspegel mit technisch einfachen Mitteln bereitzustellen, besteht zwischen der Batteriesensordatenübertragungseinheit 165 der mittleren Batteriezellen 130b kein geschlossener Stromkreis mehr mit dem Auswertungsgerät 170. Ein Sensorsignal, welches eine die mittlere Batteriezelle 130b betreffende physikalische Größe enthält, könnte dann nicht mehr zum Auswertungsgerät 170 übertragen werden.

Um dennoch eine Übertragung des Sensorsignals von der Batteriesensordatenübertragungseinheit 165 der mittleren Batteriezellen 130b in einem Zeitpunkt sicherzustellen, in dem die betreffende Batteriezelle von der Energieversorgungsleitung 140 abgekoppelt oder zumindest nicht mehr in Reihe mit weiteren Batteriezellen 130 geschaltet ist, kann die Batteriesensordatenübertragungseinheit 165 der mittleren Batteriezellen 130b beispielsweise einen hochfrequenten elektrischen Stromkreis mit dem Auswertungsgerät 170 schließen. Dies kann beispielsweise erfolgen, in dem es eine unter bestimmten Bedingungen datenübertragungsfähige Verbindung (beispielsweise als kapazitive Kopplung) über eine Wand 175 der mittleren Batteriezelle 130b und eine Batterieeinheitsgehäusewand 180 zur Auswertungseinheit 170 herstellt, wobei das Auswertungsgerät 170 ebenfalls über eine ebenfalls unter bestimmten Bedingungen datenübertragungsfähige Verbindung (beispielsweise ebenfalls in einer kapazitiven Kopplung) mit der Batterieeinheitsgehäusewand 180 gekoppelt ist. Dieser Fall der Übertragung des Sensorsignals auf die Batteriezellenwand 175 bzw. Batterieeinheitsgehäusewand 180 ist in der Fig. 1 als gestrichelte Einspeisung des Sensorsignals 168 auf die Batteriezellenwand 175 dargestellt. Nun besteht auch ohne einen über die Energieversorgungsleitungen geschlossenen Strompfad zwischen der Batteriesensordatenübertragungseinheit 165 und dem Auswertungsgerät 170 die Möglichkeit einer Übertragung des Sensorsignals 168 aus der mittleren Batteriezelle 130 an das Auswertungsgerät 170, da ein Pfad nun beispielsweise über die kapazitive Kopplung zwischen der Batteriezellenwand 175 und der Batteriegehäusewand 180 sowie zwischen der kapazitiven Kopplung zwischen der Batteriegehäusewand und der Auswertungseinheit 170 zumindest für hochfrequente Signale geschlossen wird. Alternativ oder zusätzlich zur Übertragung des Sensorsignals 168 über die Energieversorgungsleitung 140 kann auch das Sensorsignal 168 aus der betreffenden Batteriezelle 130b vollständig unter Verwendung der Wand 180 der Batterieeinheit 110 erfolgen. Unter einer Wand der Batteriezelle 130 und/oder der Batterieeinheit 110 kann dabei eine Außenwand verstanden werden, die sich von einem Pol unterscheidet, der speziell zur elektrischen Kontaktierung der Batteriezelle 130 und/oder der Batterieeinheit 110 vorgesehen ist. Insbesondere in einem Fall, in dem viele bzw. alle Batteriezellen 130 der Batterieeinheit 110 fest, das heißt statisch und nicht während des Betriebs voneinander trennbar miteinander verschaltet sind, lässt sich auf eine derartige Weise sehr einfach eine Übertragung der Sensorsignale aus den einzelnen Batteriezellen 130 bzw. den entsprechenden Batteriesensorübertragungseinheiten 165 bewerkstelligen. In diesem Fall ließe sich einerseits sicherstellen, dass jede Batteriesensordatenübertragungseinheit 165 in der Lage ist, ein entsprechendes Sensorsignal 168 an die Auswertungseinheit bzw. das Auswertungsgerät 170 übertragen und zugleich eine Bestimmung des Verschaltungszustandes der betreffenden Batteriezelle in den Serienschaltungszustand oder den Überbrückungszustand vermieden werden kann. Andererseits ist eine derartige Übertragung von Informationen über eine Gehäusewand 180 der Batterieeinheit 110 möglicherweise gegen Störungen anfälliger, als die Übertragung von Informationen über die Energieversorgungsleitung 140. Auch ist es beispielsweise denkbar, dass eine hybride Form der Datenübertragung unter Verwendung der beiden zuvor genannten Ansatz erfolgt, beispielsweise in dem eine Statusinformation über die allgemeine Betriebsbereitschaft der jeweiligen Batteriesensordatenübertragungseinheiten 165 über eine Wand 180 der Batterieeinheit 110 an das Auswertungsgerät 170 übertragen werden, wogegen die Sensorsignale, welche je eine physikalische Größe innerhalb der betreffenden Batteriezelle 130 repräsentieren, über die Energieversorgungsleitung 140 übertragen werden. In diesem Fall ließe sich beispielsweise eine Reduktion von über die Energieversorgungsleitung 140 übertragenen Informationen realisieren, wogegen Daten, die keine so hohe Update-Rate erfordern, über einen alternativen Übertragungspfad, nämlich über die Wand 180 der Batterieeinheit 110, an das Auswertungsgerät 170 übertragen werden.

Um eine besonders schnelle und effektive Umschaltung zwischen der Übertragung des Sensorsignals aus der mittleren Batteriezelle 130b zum Auswertungsgerät kann auch eine Synchronisation der Ausgabe des Sensorsignals der mittleren Batteriezelle 130b einerseits auf die Energieversorgungsleitung 140 und andererseits auf die Batteriezellenwand 180 erfolgen. Hierzu kann die Batteriesensordatenübertragungseinheit von der Verschaltungssteuerungseinheit 150 ein Signal erhalten, das ein Umschalten des Schalters 160 repräsentiert, sodass in der Batteriesensordatenübertragungseinheit 165 bereits sehr frühzeitig und ohne beispielsweise eine Messung eines Flusses von Energie über die Energieversorgungsleitung 140 erkennen kann, dass sie in den Überbrückungszustand geschaltet wurde. Auf diese Weise kann eine nahezu unterbrechungsfreie zumindest jedoch nur sehr kurzzeitig unterbrochene Datenübertragung des Sensorsignals an die Auswertungseinheit 170 sichergestellt werden.

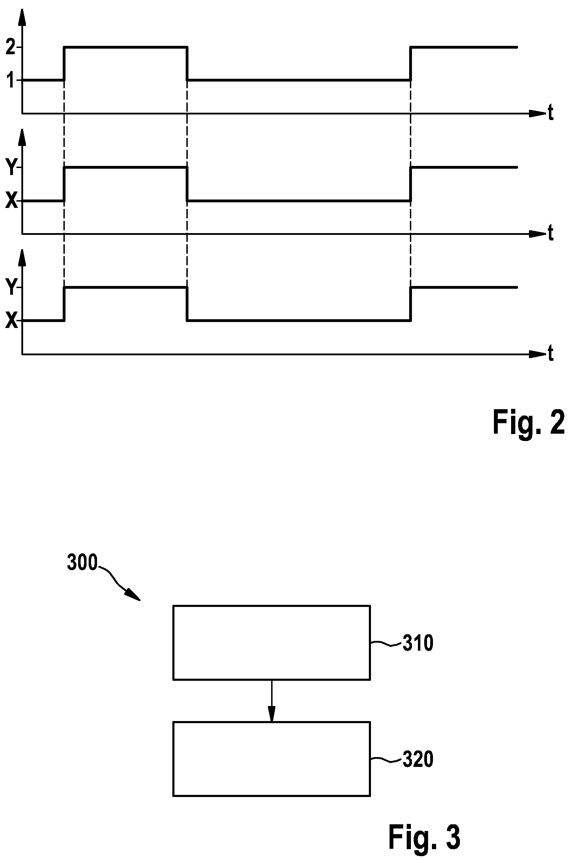

Fig. 2 zeigt in dem oberen Teildiagramm einen Verlauf von Stellungen 1 (in Fig. 1 durchgesogen dargestellte Stellung) und 2 (in der Fig. 1 gestrichelt dargestellte Stellung) des Schalters 160, wie sie durch die Verschaltungssteuerungseinheit 150 angesteuert wird. In dem mittleren Diagramm ist ein zeitlicher Wechsel zwischen dem Serienschaltungszustand X und dem Überbrückungszustand Y der mittleren Batteriezelle 130b zu entnehmen. Dabei ist ersichtlich, dass durch eine Synchronisation der Stellung des Schalters 160 und der durch den Verschaltungszustand der mittleren Batteriezelle 130b erforderlichen Schaltung eines bestimmten Pfades für die Übertragung des Sensorsignals gemäß dem unteren Teildiagramm aus der Fig. 2 (x für die Übertragung des Sensorsignals über die Energieversorgungsleitung 140, y für die Übertragung des Sensorsignals über die Masseverbindung) eine sehr einfache und robuste Übertragung des Sensorsignals von der mittleren Batteriezelle 130b zum Auswertungsgerät 170 sichergestellt werden kann.

In der Fig. 1 wurde zur besseren Verständlichkeit der Grundlagen des hier vorgestellten Ansatzes die Erläuterung der Grundidee eines Ausführungsbeispiels der Erfindung auf die Überbrückung lediglich einer Batteriezelle 130 abgestellt. Die in Fig. 1 dargestellte Verschaltung bzw. Überbrückungsmöglichkeit kann natürlich auch auf die Überbrückung von beliebig vielen einzelnen Batteriezellen 130 oder die Überbrückung von mehreren Batteriezellen 130 gleichzeitig erweitert werden, wobei das vorstehend vorgestellte Konzept auf den jeweils verwendeten Fall einfach angepasst werden kann. Auch können für die einzelnen Batteriezellen 130 zeitlich unterschiedliche lange Überbrückungszustände vorgehen sein, um eine gewünschte Spannung an den Klemmen 145 zu erhalten. Hierzu kann dann der Schalter bzw. die Schalter 160 von der Verschaltungssteuerungseinheit 150 durch (je) ein pulsweitenmoduliertes Signal angesteuert werden, sodass die gewünschte zeitliche Abfolge von Serienschaltungszuständen und Überbrückungszuständen für die einzelnen Batteriezellen implementiert werden kann.

Fig. 3 zeigt ein Ablaufdiagramm eines Ausführungsbeispiels der vorliegenden Erfindung als Verfahren 300 zur Übertragung von Batteriesensordaten. Das Verfahren umfasst einen Schritt des Bestimmens 310 eines Serienschaltungszustandes, in dem ein Pol einer Batteriezelle mit einem Pol zumindest einer weiteren Batteriezelle mittels einer Energieübertragungsleitung in Reihe geschaltet ist und/oder Bestimmen eines Überbrückungszustandes, in dem der Pol der Batteriezelle nicht mit dem einen Pol der zumindest einen weiteren Batteriezelle in Reihe geschaltet ist, d. h. in dem ein Pol der Batteriezelle von zumindest einem Pol einer weiteren Batteriezelle entkoppelt ist. Weiterhin umfasst das Verfahren 300 einen Schritt des Ausgebens 320 eines Sensorsignals, welches eine physikalische Größe in oder an der Batteriezelle repräsentiert, in dem Serienschaltungszustand unter Verwendung der Energieübertragungsleitung an ein Auswertungsgerät und/oder Ausgeben des Sensorsignals in dem Überbrückungszustand unter Verwendung einer Batteriegehäusewand als Übertragungsmedium an das Auswertungsgerät.

Zusammenfassend ist anzumerken, dass zur Umsetzung der Erfindung eine Ausführungsform einer Batterie verwendet werden kann, bei der eine Veränderung der Batteriespannung durch eine Verschaltung von unterschiedlichen Batteriezellen ermöglicht wird, wobei im Grundzustand beispielsweise alle Batteriezellen 130 in Reihe geschaltet werden können. Um eine Wechselspannung am Ausgang der Batterie 110 zu erzeugen, werden Module d. h. Batteriezellen 130 oder Gruppen davon (logische und schaltungstechnische Gruppierung mehrerer Zellen innerhalb der Batterie) in dieser Reihenschaltung überbrückt. Dadurch kann die Ausgangsspannung der Batterie 110 als Summe der nicht überbrückten Module variiert werden.

Ein Aspekt des hier vorgestellten Ansatzes besteht darin, die Kommunikation eines Sensorsystems 165, 162 innerhalb einer Batterie mit variabler Ausgangsspannung 110 zu ermöglichen, obwohl einzelne Batteriezellen aufgrund der Funktionsweise der Batterie vom Batteriezellstrang 140 abgekoppelt, bzw. überbrückt, sind. Beim überbrückten Modul 130b ist mindestens einer seiner Anschlüsse 135 durch einen Leistungsschalter 160 abgetrennt. Gleichzeitig wird auf Batterieebene eine Überbrückung der Anschlüsse 135 vorgenommen um die Serienschaltung der restlichen Module 130a bzw. 130c aufrechtzuerhalten. Damit bildet das Modul 130b einen Seitenast mit totem Ende im Batteriestrang 140, es ist keine Powerline-Kommunikation mehr möglich.

Der vorstehend vorgestellte Aspekt zielt dabei insbesondere darauf ab, die Beschränkung einer Kommunikation via Powerline auf die Phasen in denen die Daten austauschende Zelle 130 nicht vom Rest des Batteriestranges 140 abgehängt. Dies kann durch Synchronisation der Kommunikation mit der Pulsweitenmodulationsfrequenz der Batterie mit variabler Ausgangsspannung erfolgen. Ein derartiger Ansatz bietet mehrere Vorteile, beispielsweise die Möglichkeit eine Kommunikation trotz zeitweise unterbrochener Übertragungsstrecke zu ermöglichen. Auch wird ohne zusätzlichen Schaltungsaufwand eine Powerline-Kommunikation innerhalb einer Batterie mit variabler Ausgangsspannung ermöglicht. Ein derartiger Ansatz kann generell bei allen solchen Batterien verwendet werden.

Ein anderer Aspekt der vorliegenden Erfindung gemäß einem Ausführungsbeispiel ermöglicht die Nutzung des Batterie(zellen)gehäuses um den Übertragungspfad vom Seitenast zum Auswertungsgerät wiederherzustellen. Ein Übertragungspfad benötigt einen DC oder zumindest hochfrequent geschlossenen Stromkreis. Dies ist beim abgekoppelten Seitenast 130b nicht gegeben, dieser kann aber über kapazitive Kopplung vom Sensorsystem zum mit Fahrzeugmasse verbundenen Batteriegehäuse wiederhergestellt werden. Dieser Aspekt der vorliegenden Erfindung bietet ebenfalls Vorteile, beispielsweise ist auch eine Kommunikation innerhalb einer Batterie mit variabler Ausgangsspannung möglich bei der einzelne Zellen oder Zellmodule abgekoppelt werden. Auch dieser Aspekt kann generell bei allen Batterien mit variabler Ausgangsspannung verwendet werden.

Die Erfindung lässt sich besonders vorteilhaft als Vorrichtung, bzw. Ausprägung eines Sensorsystems mit elektrischen und elektronischen Komponenten verwenden, welches in eine Batteriezelle (z. B. Lithium-Ionen Batterie eines Elektrofahrzeuges) ein- oder angebaut werden kann. Der vorstehend vorgestellte Ansatz dient dazu, Daten zwischen dem Sensorsystem und einem zentralen Auswertungsgerät auszutauschen, obwohl einzelne Batteriezellen aufgrund der Funktionsweise des in der Batterie eingesetzten Verfahrens zur Generierung einer variablen Ausgangsspannung vom Batteriezellstrang abgekoppelt, bzw. überbrückt, sind.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Batteriesensordatenübertragungseinheit (165) mit folgenden Merkmalen:
- einer Verschaltungszustandsermittlungseinheit (166) zur Ermittlung eines Serienschaltungszustandes, in dem eine Batteriezelle (130b) mit einer weiteren Batteriezelle (130a, 130c) mittels einer Energieübertragungsleitung (140) in Reihe geschaltet ist und/oder zur Bestimmung eines Überbrückungszustandes, in dem zumindest ein Pol der Batteriezelle (130b) von zumindest einer weiteren Batteriezelle (130a, 130c) entkoppelt ist; und
- eine Datenübermittlungseinheit (167), die ausgebildet ist, um ein Sensorsignal (168), welches eine physikalische Größe in oder an der Batteriezelle (130b) repräsentiert, in dem Serienschaltungszustand unter Verwendung der Energieübertragungsleitung (140) an ein Auswertungsgerät (170) auszugeben und/oder um das Sensorsignal (168) in dem Überbrückungszustand unter Verwendung einer Batteriegehäusewand (180) als Übertragungsmedium an das Auswertungsgerät (170) auszugeben.

2. Batteriesensordatenübertragungseinheit (165) gemäß Anspruch 1, **dadurch gekennzeichnet, dass** die Verschaltungszustandsermittlungseinheit (166) ausgebildet ist, um den Serienschaltungszustand dann zu bestimmen, wenn Pole (135) von zumindest drei Batteriezellen (130a, 130b, 130c) unter Verwendung der Energieübertragungsleitung (140) in Reihe geschaltet sind.

3. Batteriesensordatenübertragungseinheit (165) gemäß einem der vorangegangenen Ansprüche, **dadurch gekennzeichnet, dass** die Verschaltungszustandsermittlungseinheit (166) ausgebildet ist, um den Serienschaltungszustand oder den Überbrückungszustand unter Auswertung einer Stellung eines Schalters (160) zu bestimmen, der ausgebildet ist, um eine elektrische Kopplung eines Pols (135) der Batteriezelle (130b) an die Energieübertragungsleitung (140) durchzuführen.

4. Batteriesensordatenübertragungseinheit (165) gemäß einem der vorangegangenen Ansprüche, **dadurch gekennzeichnet, dass** die Verschaltungszustandsermittlungseinheit (166) ausgebildet ist, um den Serienschaltungszustand oder den Überbrückungszustand unter Verwendung eines Messergebnisses in Bezug auf einem Strom-, Energie- und/oder Leistungsfluss über die Energieversorgungsleitung (140) zu ermittlen.

5. Batteriesensordatenübertragungseinheit (165) gemäß Anspruch 3, bei der der Schalter (160) unter Verwendung eines Steuersignals (155), insbesondere eines pulsweitenmodulierten Steuersignals (155), angesteuert wird, **dadurch gekennzeichnet, dass** die Datenübermittlungseinheit (167) ausgebildet ist, um eine Ermittlung oder Ausgabe des Sensorsignals (168) mit dem Steuersignal (155) zu synchronisieren.

6. Batteriesensordatenübertragungseinheit (165) gemäß einem der vorangegangenen Ansprüche, **dadurch gekennzeichnet, dass** die Datenübermittlungseinheit (167) ausgebildet ist, um das Sensorsignal (168), in dem Serienschaltungszustand unter Verwendung der Energieübertragungsleitung (140) an ein Auswertungsgerät (170) auszugeben und/oder um das Sensorsignal (168) in dem Überbrückungszustand unter Verwendung einer Batteriegehäusewand (180) als Übertragungsmedium an das Auswertungsgerät (170) auszugeben.

7. Batteriesensordatenübertragungseinheit (165) gemäß einem der vorangegangenen Ansprüche, **dadurch gekennzeichnet, dass** die Datenübermittlungseinheit (167) ausgebildet ist, um das Sensorsignal (168) in einem der Batteriezelle (130b) eindeutig zuordenbaren Sensorsignalpaket zu codieren.

8. Batterieeinheit (110) mit folgenden Merkmalen:
- einem Batteriezellenverbund (130), der zumindest zwei Batteriezellen (130a, 130b, 130c) umfasst, wobei die Batteriezellen (130a, 130b, 130c) mittels einer Energieübertragungsleitung (140) in Reihe schaltbar sind;
- zumindest einem Sensor (162) zur Bereitstellung eines Messwertes, der eine physikalische Größe in oder an einer der Batteriezellen (130a, 130b, 130c) repräsentiert; und
- zumindest eine Batteriesensordatenübertragungseinheit (165) gemäß einem der vorangegangenen Ansprüche.

9. Verfahren (300) zur Übertragung von Batteriesensordaten, wobei das Verfahren (300) die folgenden Schritte aufweist:
- Ermitteln (310) eines Serienschaltungszustandes, in dem eine Batteriezelle (130b) mit zumindest einer weiteren Batteriezelle (130a, 130c) mittels einer Energieübertragungsleitung (140) in Reihe geschaltet ist und/oder Ermitteln (310) eines Überbrückungszustandes, in dem ein Pol (135) der Batteriezelle (130b) entkoppelt von zumindest einer weiteren Batteriezelle (130a, 130c) ist; und
- Ausgeben (320) eines Sensorsignals (168), welches eine physikalische Größe in oder an der Batteriezelle (130b) repräsentiert, in dem Serienschaltungszustand unter Verwendung der Energieübertragungsleitung (140) an ein Auswertungsgerät (170) und/oder Ausgeben (320) des Sensorsignals (168) in dem Überbrückungszustand unter Verwendung einer Batteriegehäusewand (180) als Übertragungsmedium an das Auswertungsgerät (170).

10. Computer-Programm mit Programmcode zur Durchführung des Verfahrens (300) nach Anspruch 8, wenn das Programm auf einer Vorrichtung, einer Batteriesensordatenübertragungseinheit (165) oder einer Datenverarbeitungsanlage ausgeführt wird.

## Claims

1. Battery sensor data transmission unit (165) having the following features:
- a connection state determination unit (166) for determining a series connection state in which a battery cell (130b) is connected in series with a further battery cell (130a, 130c) by means of an energy transmission line (140) and/or for determining a bypass state in which at least one pole of the battery cell (130b) is decoupled from at least one further battery cell (130a, 130c); and
- a data transmission unit (167) which is designed to output a sensor signal (168) representing a physical variable in or on the battery cell (130b) to an evaluation device (170) in the series connection state using the energy transmission line (140) and/or to output the sensor signal (168) to the evaluation device (170) in the bypass state using a battery housing wall (180) as the transmission medium.

2. Battery sensor data transmission unit (165) according to Claim 1, **characterized in that** the connection state determination unit (166) is designed to determine the series connection state when poles (135) of at least three battery cells (130a, 130b, 130c) are connected in series using the energy transmission line (140).

3. Battery sensor data transmission unit (165) according to one of the preceding claims, **characterized in that** the connection state determination unit (166) is designed to determine the series connection state or the bypass state by evaluating a position of a switch (160) which is designed to electrically couple a pole (135) of the battery cell (130b) to the energy transmission line (140).

4. Battery sensor data transmission unit (165) according to one of the preceding claims, **characterized in that** the connection state determination unit (166) is designed to determine the series connection state or the bypass state using a measurement result with respect to a flow of current, energy and/or power via the energy supply line (140).

5. Battery sensor data transmission unit (165) according to Claim 3, in which the switch (160) is controlled using a control signal (155), in particular a pulse-width-modulated control signal (155), **characterized in that** the data transmission unit (167) is designed to synchronize determination or output of the sensor signal (168) with the control signal (155).

6. Battery sensor data transmission unit (165) according to one of the preceding claims, **characterized in that** the data transmission unit (167) is designed to output the sensor signal (168) to an evaluation device (170) in the series connection state using the energy transmission line (140) and/or to output the sensor signal (168) to the evaluation device (170) in the bypass state using a battery housing wall (180) as the transmission medium.

7. Battery sensor data transmission unit (165) according to one of the preceding claims, **characterized in that** the data transmission unit (167) is designed to code the sensor signal (168) in a sensor signal packet which can be uniquely assigned to the battery cell (130b).

8. Battery unit (110) having the following features:
- a battery cell assembly (130) comprising at least two battery cells (130a, 130b, 130c), the battery cells (130a, 130b, 130c) being able to be connected in series by means of an energy transmission line (140);
- at least one sensor (162) for providing a measured value representing a physical variable in or on one of the battery cells (130a, 130b, 130c); and
- at least one battery sensor data transmission unit (165) according to one of the preceding claims.

9. Method (300) for transmitting battery sensor data, the method (300) comprising the following steps of:
- determining (310) a series connection state in which a battery cell (130b) is connected in series with at least one further battery cell (130a, 130c) by means of an energy transmission line (140) and/or determining (310) a bypass state in which a pole (135) of the battery cell (130b) is decoupled from at least one further battery cell (130a, 130c); and
- outputting (320) a sensor signal (168) representing a physical variable in or on the battery cell (130b) to an evaluation device (170) in the series connection state using the energy transmission line (140) and/or outputting (320) the sensor signal (168) to the evaluation device (170) in the bypass state using a battery housing wall (180) as the transmission medium.

10. Computer program having program code for carrying out the method (300) according to Claim 8 when the program is executed on an apparatus, a battery sensor data transmission unit (165) or a data processing system.

## Revendications

1. Unité de transmission de données de capteur de batterie (165) comprenant les éléments caractéristiques suivants :
- une unité de communication d'état de connexion (166) destinée à communiquer un état de connexion en série dans lequel une cellule de batterie (130b) est connectée en série à une autre cellule de batterie (130a, 130c) au moyen d'une ligne de transmission d'énergie (140) et/ou pour déterminer un état de court-circuit dans lequel au moins un pôle de la cellule de batterie (130b) est découplé d'au moins une autre cellule de batterie (130a, 130c) ; et
- une unité de communication de données (167) qui est conçue pour délivrer un signal de capteur (168) représentant une grandeur physique dans ou sur la cellule de batterie (130b) dans l'état de connexion en série par utilisation de la ligne de transmission d'énergie (140), à un appareil d'évaluation (170), et/ou pour délivrer le signal de capteur (168) dans l'état de court-circuit par utilisation d'une paroi de boîtier de batterie (180) comme milieu de transmission, à l'appareil d'évaluation (170).

2. Unité de transmission de données de capteur de batterie (165) selon la revendication 1, **caractérisée en ce que** l'unité de communication d'état de connexion (166) est conçue pour ne déterminer l'état de connexion en série que lorsque des pôles (135) d'au moins trois cellules de batterie (130a, 130b, 130c) sont connectés en série par utilisation de la ligne de transmission d'énergie (140).

3. Unité de transmission de données de capteur de batterie (165) selon l'une quelconque des revendications précédentes, **caractérisée en ce que** l'unité de communication d'état de connexion (166) est conçue pour déterminer l'état de connexion en série ou l'état de court-circuit par évaluation d'une position d'un commutateur (160) qui est conçu pour réaliser un couplage électrique d'un pôle (135) de la cellule de batterie (130b) à la ligne de transmission d'énergie (140).

4. Unité de transmission de données de capteur de batterie (165) selon l'une quelconque des revendications précédentes, **caractérisée en ce que** l'unité de communication d'état de connexion (166) est conçue pour déterminer l'état de connexion en série ou l'état de court-circuit par utilisation d'un résultat de mesure concernant un flux de courant, d'énergie et/ou de puissance sur la ligne d'alimentation en énergie (140).

5. Unité de transmission de données de capteur de batterie (165) selon la revendication 3, dans laquelle le commutateur (160) est commandé par utilisation d'un signal de commande (155), notamment d'un signal de commande (155) modulé par modulation d'impulsion en largeur, **caractérisé en ce que** l'unité de communication de données (167) est conçue pour synchroniser une détermination ou une sortie du signal de capteur (168) avec le signal de commande (155).

6. Unité de transmission de données de capteur de batterie (165) selon l'une quelconque des revendications précédentes, **caractérisée en ce que** l'unité de communication de données (167) est conçue pour délivrer le signal de capteur (168) dans l'état de connexion en série par utilisation de la ligne de transmission énergie (140), à un appareil d'évaluation (170), et/ou pour délivrer le signal de capteur (168) dans l'état de court-circuit par utilisation d'une paroi de boîtier de batterie (180) comme milieu de transmission, à l'appareil d'évaluation (170).

7. Unité de transmission de données de capteur de batterie (165) selon l'une quelconque des revendications précédentes, **caractérisée en ce que** l'unité de communication de données (167) est conçue pour coder le signal de capteur (168) en un paquet de signal de capteur pouvant être associé de manière unique à la cellule de batterie (130b).

8. Unité de batterie (110) comportant les éléments caractéristiques suivants :
- une connexion de cellules de batterie (130) qui comprend au moins deux cellules de batterie (130a, 130b, 130c), dans laquelle les cellules de batterie (130a, 130b, 130c) peuvent être connectées en série au moyen d'une ligne de transmission d'énergie (140) ;
- au moins un capteur (162) destiné à fournir une valeur de mesure qui représente une grandeur physique dans ou sur l'une des cellules de batterie (130a, 130b, 130c) ; et
- au moins une unité de transmission de données de capteur de batterie (165) selon l'une quelconque des revendications précédentes.

9. Procédé (300) de transmission de données de capteur de batterie, dans lequel le procédé (300) comprend les étapes consistant à :
- déterminer (310) un état de connexion en série dans lequel une cellule de batterie (130b) est connectée en série à au moins une autre cellule de batterie (130a, 130c) au moyen d'une liaison de transmission d'énergie (140) et/ou pour déterminer (310) un état de court-circuit dans lequel un pôle (135) de la cellule de batterie (130b) est découplé d'au moins une autre cellule de batterie (130a, 130c) ; et
- délivrer (320) un signal de capteur (168) qui représente une grandeur physique dans ou sur la cellule de batterie (130b) dans l'état de connexion en série par utilisation de la ligne de transmission d'énergie (140), à un appareil d'évaluation (170), et/ou pour délivrer (320) le signal de capteur (168) dans l'état de court-circuit par utilisation d'une paroi de boîtier de batterie (180) comme milieu de transmission, à l'appareil d'évaluation (170).

10. Programme d'ordinateur comportant un code de programme destiné à mettre en oeuvre le procédé (300) selon la revendication 8 lorsque le programme est exécuté sur un dispositif, une unité de transmission de données de capteur de batterie (165) ou un système de traitement de données.
